# EUROPEAN PATENT APPLICATION

(11) **EP 4 354 735 A1**
(43) Date of publication of application: **17.04.2024**
(21) Application number: 22201508.3
(22) Date of filing: 14.10.2022
(51) Int. Cl.: H03K 17/968, H03K 17/969, B60K 37/06

(54) **SWITCHING MODULE FOR VEHICLE POWER WINDOW**

(71) Applicant: DAV, 94000 Créteil (FR)
(72) Inventor: Radhakrishnan, Rakeshlal, 94000 Créteil (FR)
(74) Representative: Delplanque, Arnaud

(57) **Abstract**

The present invention refers to a switching module (1) for vehicle power window comprising:
- a movable lever (7) comprising a patterned reflective surface (9) and configured to be actuated by a user,
- a light source (13) configured for lighting up the patterned reflective surface (9),
- a photodetector (11) configured for detecting the light reflected by the patterned reflective surface (9),
- a processing unit (19) configured for determining the position of the movable lever (7) based on the light detected by the photodetector (11).

## Description

### TECHNICAL FIELD

The present invention refers to the field of vehicle power windows and in particular to a switching module for controlling a vehicle power window.

### BACKGROUND OF THE INVENTION

Different technologies are used for the switches of power windows in today's cars. In particular, mechanical switches are widely used but can be worn rapidly in case of frequent use so that their lifetime may be shorter than the lifetime of the vehicle which would be a problem. In order to overcome such wear problem, contactless switches based on Hall effect sensors have been developed but such sensors are costly as they need an additional magnet and the displacement of the magnet need to be large enough to be detected so that it is difficult to miniaturized them.

It is therefore a goal of the invention to provide a switching module for vehicle power window with an improved lifetime with respect to the known mechanical switches, a limited cost and small size.

### SUMMARY OF THE INVENTION

The present invention refers to a switching module for vehicle power window comprising :
- a movable lever comprising a patterned reflective surface and configured to be actuated by a user,
- a light source configured for lighting up the patterned reflective surface,
- a photodetector configured for detecting the light reflected by the patterned reflective surface,
- a processing unit configured for determining the position of the movable lever based on the light detected by the photodetector.

The use of a movable lever comprising a patterned reflective surface and a photodetector configured for detecting a position of the lever according to the reflected light enables providing a switching module without mechanical friction leading therefore to an increased lifetime.

According to another aspect of the invention, the light source is a light emitting diode.

According to a further aspect of the invention, the switching module also comprises a lens configured for focusing the light reflected by the patterned reflective surface towards the photodetector.

According to another aspect of the invention, the photodetector is a complementary metal oxide semiconductor "CMOS" sensor.

According to another aspect of the invention, the movable lever is configured for pivoting around a rotation axis.

According to a further aspect of the invention, the movable lever is configured for translating between two extremal positions.

According to another aspect of the invention, the switching module also comprises haptic means associated with the movable lever and configured for providing a haptic feel to the user for different predefined positions of the movable lever.

According to a further aspect of the invention, the haptic means comprise mechanical means or electromagnetic means.

According to another aspect of the invention, the switching module comprises an additional movable lever comprising an additional patterned reflective surface and configured to be actuated by a user, wherein the light source is also configured for lighting up the additional patterned reflective surface and wherein the photodetector is also configured for detecting the light reflected by the additional patterned reflective surface and wherein the processing unit is also configured for determining the position of the additional movable lever based on the light detected by the photodetector.

The present invention also refers to a vehicle door comprising a power window and a switching module as described above.

### BRIEF DESCRIPTION OF THE DRAWINGS

Fig.1 is a perspective view of a switching module comprising four actuators and additional switches;
Fig.2 is a diagram of a patterned reflective surface arranged on a movable lever, a light source and a photodetector;
Fig.3 represents a movable lever of an actuator according to the present invention in four different positions;
Fig.4 is a cut-view of the electronic parts of an actuator according to the present invention;
Fig.5 is a perspective diagram of the different movable levers, light sources and photodetectors of the switching module of Fig. 1;
Fig.6a and Fig.6b represent diagrams of two actuators with mutualized parts;
Fig.7a to Fig.7h represent examples of patterns of a first type usable for the patterned reflective surface;
Fig.8a to Fig.8c represent examples of patterns of a second type usable for the patterned reflective surface.
Figs.9a and 9b represent examples of pictures taken a photodetector of the switching module.

### DETAILED DESCRIPTION OF THE INVENTION

The following achievements are examples. Although, the specification refers to one or several embodiments, it does not imply that each reference refers to the same embodiment or that the features apply only to a single embodiment. Simple features of different embodiments can also be combined to provide other embodiments.

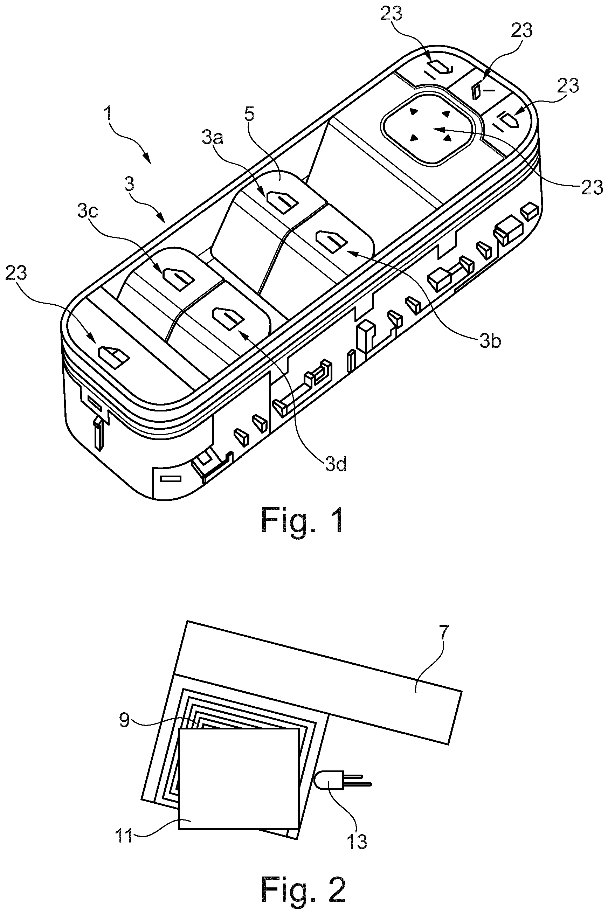

The present invention refers to a switching module 1 for vehicle power window. Fig.1 represents an example of such switching module 1. In the example of Fig.1, the switching module 1 comprises four actuators 3 noted respectively 3a, 3b, 3c and 3d and configured for controlling four respective power windows of the vehicle, for example the power windows of four different doors. The actuators 3 are configured to be handled by the user to control the power window. Such switching module 1 is for example implemented on the driver's door and may comprise additional switches 23 or actuators, for example for controlling a rear-view mirror or a door lock. Switching modules 1 with a different number of actuators 3 and notably with a single actuator 3 or with two actuators 3 may also be used without departing from the scope of the present invention. In the example of Fig.1, the actuators 3 are made by a handle 5 arranged around a rotating axis or rotating shaft (not visible) so that the handle 5 can be toggled in a first direction by pushing the handle 5 downward for opening the associated power window and in a second direction by pulling the handle 5 upward for closing the associated power window. Other types of actuators 3 may also be used.

The actuator 3 also comprises a movable lever 7 (visible in Fig.2) configured to be toggled with the handle 5 (the handle 5 and the movable lever 7 may be a single part).

Alternatively, the movable lever 7 may be arranged to be translated between two extreme positions. Different intermediate positions may be defined within the range covering the extreme positions. Other displacement of the movable lever 7 such as a combination of a translation and a rotation may also be implemented. The movable lever 7 may be arranged in a lower part of the actuator 3 and therefore be hidden for the user as in the case of Fig.1.

Fig.2 represents a diagram of an example of movable lever 7. The movable lever 7 comprises a patterned reflective surface 9 configured to be displaced in front of a photodetector 11, the patterned reflective surface being lighted up by a light source 13. Furthermore, haptic means may be associated with the movable lever 7 in order to provide a haptic feel or haptic feedback to the user when the movable lever 7 is switched from a position to another position. These haptic means may comprise mechanical parts such as friction part, elastic means such as spring, magnetic means such as magnets or electromagnetic means such as electromagnets or any other means known by the man skilled in the art and providing a haptic feedback to the user.

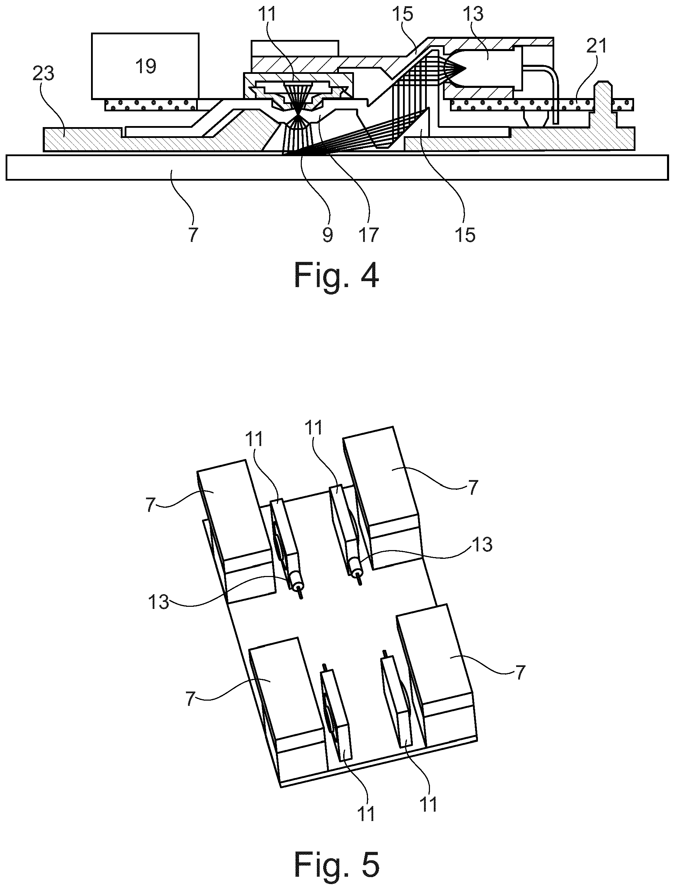

Fig.4 represents an example embodiment of the different elements enabling the detection of the position of the actuator 3 of the switching module 1.

The switching module 1 comprises a light source 13 configured for lighting up the patterned reflective surface 9. The light source 13 is for example made of a light-emitting diode (LED). One or several optical means(s) such as mirrors 15 or lens 17 may be used to direct and/or to focus the light emitted by the light source 13 toward the patterned reflective surface 9 and then to direct or focus the reflected light toward the photodetector 11. Such optical means enable obtaining a compact switching module 1. In the example of Fig.4, two mirrors 15 are used to direct the light emitted by the light source 13 toward the patterned reflective surface 9 and one lens 17 is used to focus the reflected light toward the photodetector 11. The photodetector 11 is configured for detecting the light reflected by the patterned reflective surface 9. The photodetector 11 is for example a complementary metal oxide semiconductor (CMOS) sensor but other types of photodetectors 11 may be also be used.

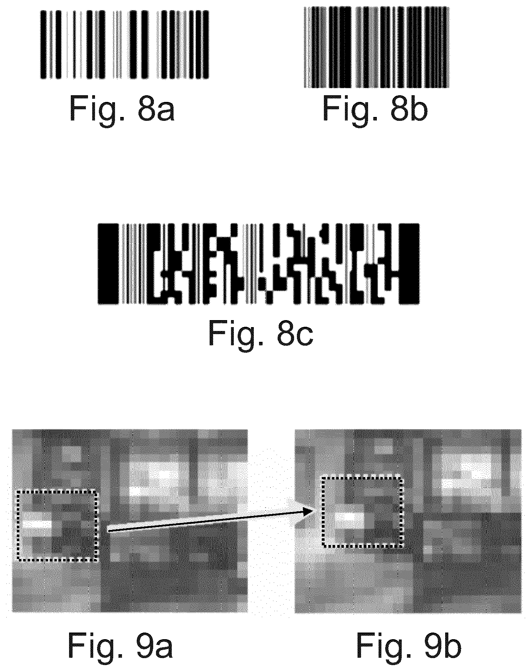

The switching module 1 also comprises a processing unit 19 configured for determining the position of the movable lever 7 and therefore of the actuator 3 based on the light detected by the photodetector 11. Indeed, as the reflected surface 9 is patterned, depending on the position (tilted angle due to the toggling of the actuator 3) of the movable lever 7, the reflected light detected by the photodetector 11 will be different so that the position (angle) of the movable lever 7 may be determined based on the detected light. The processing unit 19 is for example configured to apply digital signal processing to the images sent by the photodetector 11. The light emitted by the light source 13 is reflected by the reflective surface 9 back towards the photodetector 11 and picked up by sensing part of the photodetector 11 forming an image of the local surface. Hundreds or thousands of pictures may be taken every second by the photodetector 11. These pictures are then sent to the processing unit 19 to apply digital signal processing for comparing the different pictures to determine whether the reflective surface 9 has moved with respect to the photodetector 11. The processing unit 19 is configured to determine the direction and possibly the speed of the displacement of the reflective surface 9. Fig.9 represents an example of a frame transmitted to the processing unit 19. The processing unit 19 is capable of detecting a particular pattern (which is surrounded by the dotted line in Fig.9) and its associated position in the frame. Then, on a following frame represented in Fig.9b, the pattern detected in the frame of Fig.9a is also detected at a different position. The change of position corresponds to the displacement of the movable lever 7 so that the processing unit 19 may determine the displacement of the movable lever 7 between the instants of the frame associated with Fig.9a and the frame associated with Fig.9b. Thus, the displacement of the movable lever 7 may be detected and monitored along time by the processing unit 19.

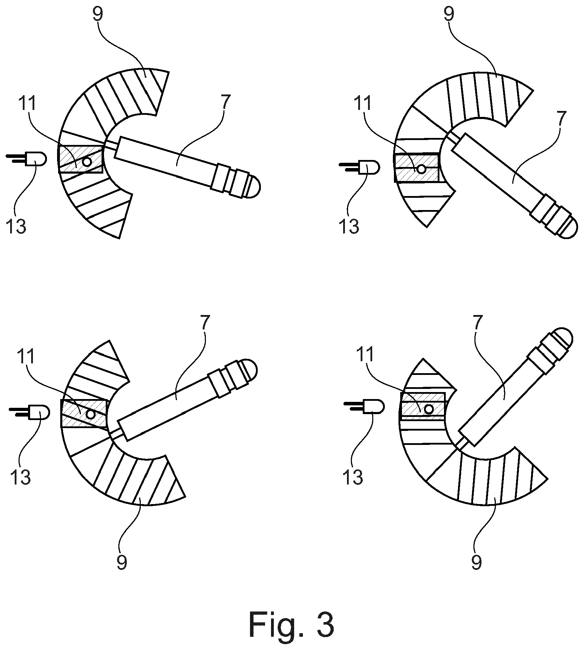

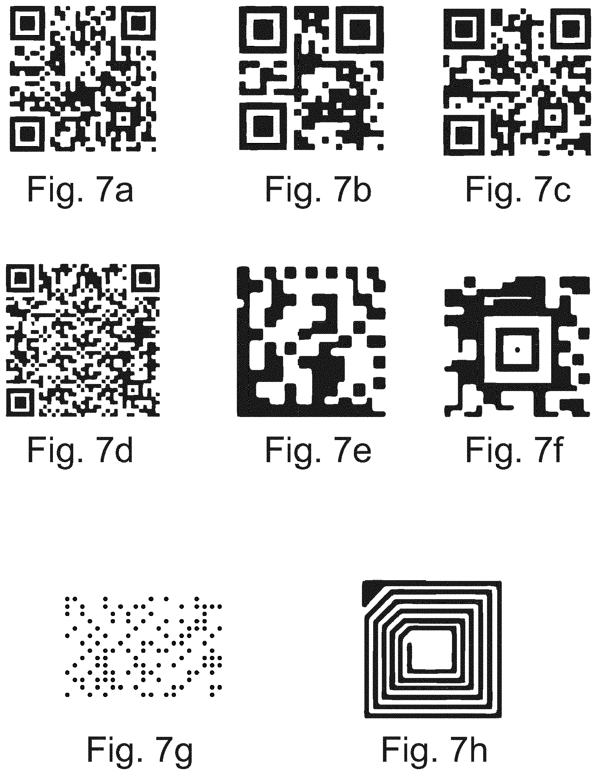

Fig.3 represents a movable lever 7 in four different positions associated with four different reflective patterns of the light emitted by the light source 13 and reflected toward the photodetector 11 by the patterned reflective surface 9 so that the processing unit 19 may differentiate the different positions of the movable lever 7. The pattern of the reflective surface 9 may correspond to stripes (or other geometric shapes) with different reflective indexes or to embossed pattern having different reflective directions or any other patterns leading to different patterns of reflective light when the actuator is moved from one position to the other. As represented in Fig.7a to Fig.7f, the patterns may correspond to QR code designs. The patterns may also refer to an arrangement of dots as represented in fig.7g or a line having a spiral shape as represented in Fig.7h. Alternatively, the patterns may be in a shape of a barcode as represented in Fig.8a to 8c. The usable patterns are not limited by the examples provided in the different figures. These different patterns enable detecting a displacement of the movable lever 7 due to the differences of reflection of the light emitted by the light source 13 when the movable lever 7 is moved in a particular direction or in any direction.

The processing unit 19 may be remote with respect to the other elements of the switching module 1, for example in a central controller of the vehicle. The processing unit 19 may be a microcontroller or a processor associated to a memory. As represented in Fig.4, the switching module 1 may comprise a printed card board (PCB) 21 for receiving the different electronic components such as the photodetector 11, the light source 13, the processing unit 19 and for providing power supply to these elements. The PCB may be implemented on a base plate 23. The light source 13 may be switched on continuously when the switching module 1 is powered and the photodetector 11 may be configured to take pictures at a predetermined frequency, for example 1000 frames per second so that a displacement of a movable lever (and of the associated patterned reflective surface 9) is detected almost instantly by the photodetector 11 and the processing unit 19.

Fig.5 represents an implementation of a switching module 1 with four light sources 13, four photodetectors 11 and four movable levers 7 corresponding to the four actuators 3 presented in Fig.1.

Furthermore, when two (or more) actuators 3 are adjacent to each other, some elements may be mutualized between the actuators 3 to reduce the overall cost of the switching module 1. In particular, a single light source 13 may be used for several actuators 3. It is also possible to use a single photodetector 11 configured for detecting the light reflected by several patterned reflective surfaces 9 associated with different movable levers 7, the different combinations of positions of the movable levers 7 leading to different pattern of the reflected light so that the photodetector 11 may detect a change of position of the different movable levers 7.

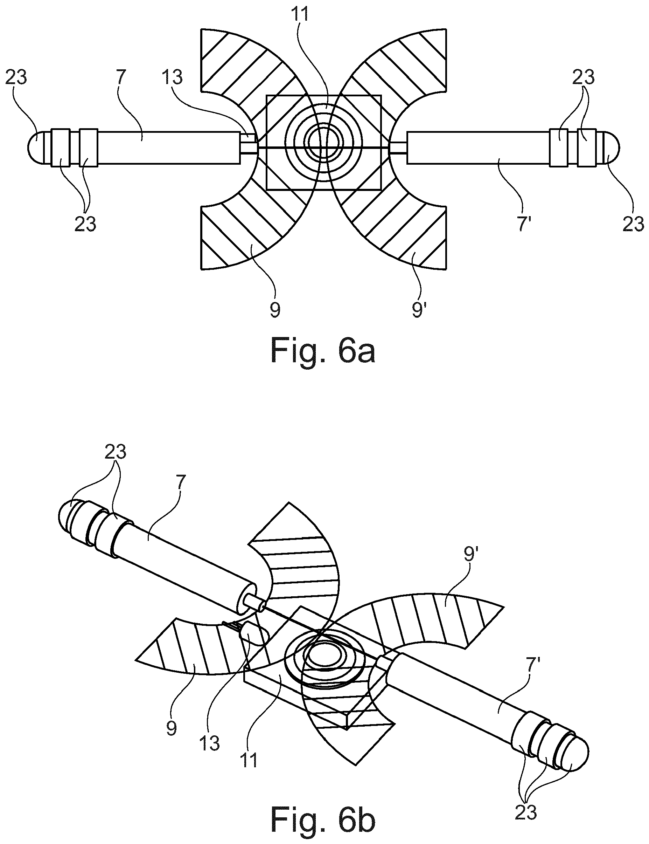

Figs.6a and 6b represents an example of a switching module 1 with a first movable lever 7 and an additional movable lever 7' associated respectively with a first patterned reflective surface 9 and an additional patterned reflective surface 9' adjacent to the first patterned reflected surfaces 9. Both patterned reflective surfaces 9, 9' being arranged in front of a single photodetector 11 and lighted up by a single light source 13. Thus, the different combinations of positions of the movable levers 7, 7' produce different reflective light patterns that can be differentiated by the photodetector 11 and the processing unit 19. Such mutualization of the elements of the switching module 1 allows reducing the overall cost of the switching module 1.

As represented in Fig.6a and 6b, the movable lever 7 may comprise additional switches 23 such as a push switches or rotary switches which may be associated to a function of the vehicle power window or to another equipment of the vehicle such as a rear mirror.

The present invention also refers to a vehicle door comprising a power window and a switching module 1 as described previously to enables a user to activate the power window.

## Claims

1. Switching module (1) for vehicle power window comprising :
- a movable lever (7) comprising a patterned reflective surface (9) and configured to be actuated by a user,
- a light source (13) configured for lighting up the patterned reflective surface (9),
- a photodetector (11) configured for detecting the light reflected by the patterned reflective surface (9),
- a processing unit (19) configured for determining the position of the movable lever (7) based on the light detected by the photodetector (11).

2. Switching module (1) in accordance with claim 1 wherein the light source (13) is a light emitting diode.

3. Switching module (1) in accordance with one of the previous claims wherein it also comprises a lens (17) configured for focusing the light reflected by the patterned reflective surface (9) towards the photodetector (11).

4. Switching module (1) in accordance with one of the previous claims wherein the photodetector (11) is a complementary metal oxide semiconductor "CMOS" sensor.

5. Switching module (1) in accordance with one of the previous claims wherein the movable lever (7) is configured for pivoting around a rotation axis.

6. Switching module (1) in accordance with one of the claims 1 to 4 wherein the movable lever (7) is configured for translating between two extremal positions.

7. Switching module (1) in accordance with one of the previous claims also comprising haptic means associated with the movable lever (7) and configured for providing a haptic feel to the user for different predefined positions of the movable lever (7).

8. Switching module (1) in accordance with the previous claim wherein the haptic means comprises mechanical means or electromagnetic means.

9. Switching module (1) in accordance with one of the previous claims wherein it comprises an additional movable lever (7') comprising an additional patterned reflective surface (9') and configured to be actuated by a user,
wherein the light source (13) is also configured for lighting up the additional patterned reflective surface (9') and wherein the photodetector (11) is also configured for detecting the light reflected by the additional patterned reflective surface (9') and wherein the processing unit (19) is also configured for determining the position of the additional movable lever (7') based on the light detected by the photodetector (11).

10. Vehicle door comprising a power window and a switching module (1) in accordance with one of the previous claims.
